# EUROPEAN PATENT SPECIFICATION

(11) **EP 0 345 757 B1**
(45) Date of publication and mention of the grant of the patent: **03.09.1997**
(21) Application number: 89110295.6
(22) Date of filing: 07.06.1989
(51) Int. Cl.: H01L 21/31

(54) **An ashing method for removing an organic film on a substance of a semiconductor device under fabrication**
Veraschungsverfahren zum Entfernen einer organischen Schicht auf einer Halbleiteranordnung während ihrer Herstellung
Enlèvement d'une couche organique sur un dispositif semi-conducteur pendant sa fabrication par réduction en cendres

(30) Priority: 09.06.1988 JP 142673/88
(43) Date of publication of application: 13.12.1989
(60) Divisional application: 95103878.5
(73) Proprietor: FUJITSU LIMITED, Kawasaki-shi, Kanagawa 211 (JP)
(72) Inventor: Shinagawa, Keisuke, Kawasaki-shi Kanagawa, 211 (JP); Fujimura, Shuzo, Edogawa-ku Tokyo, 133 (JP); Hikazutani, Kenichi, Kuwana-shi Mie, 511 (JP)
(74) Representative: Schmidt-Evers, Jürgen, Dipl.-Ing.

(56) References cited:
- EP-A- 0 304 046
- EP-A- 0 305 946
- US-A- 3 837 856
- US-A- 4 473 437
- JOURNAL OF THE ELECTROCHEMICAL SOCIETY, vol. 134, no. 8, August 1987, pages 2045-2048, Manchester, NH, US; O. KROGH et al.: "Spectroscopic diagnostics of photoresist erosion in an aluminum etch plasma"

## Description

### BACKGROUND OF THE INVENTION

### (1) Field of The Invention

The present invention relates to a removing method of an organic material used in a semiconductor device, and particularly the present invention relates to an ashing method of an organic film temporarily formed on a substance of a semiconductor device under fabrication.

An organic film such as a resist or a polyimide film temporarily formed on a substance, which is a part of a semiconductor device, for fabricating the semiconductor device was usually removed by an ashing method using oxygen plasma. Removing the resist film is an important process in fabrication of the semiconductor device, removing the resist film as an organic film will be described, hereinafter. Since the semiconductor device becomes very small as a Large Scale Integration circuit device (LSI) or a Very Large Scale Integrated circuit device (VLSI), the resist film, which will be called simply the "resist" hereinafter, becomes hard to be removed by the usual ashing method using the oxygen plasma without damaging the devices. Because, the property of the resist is changed during the process of ion implantation and dry etching, which are widely performed in the fabricating process of the LSI or the VLSI, so that a long time is required for performing ashing, in other words, the ashing rate of the resist becomes small. Since the resist is used many times in the fabrication process of the LSI or the VLSI, the ashing rate for each resist should be large to improve the throughput of the fabrication of the LSI or the VLSI.

A layer, called simply a "ground layer" hereinafter and the resist is formed thereon, is usually made of material such as silicon dioxide (SiO₂), polysilicon (Si) or aluminum (Al). Generally, the resist is not easy to be etched intentionally by the the ashing method, in other words, the resist is hard to be etched precisely so as to be removed only the resist without damaging any of the ground layer in the ashing process. Therefore, when the ashing method is applied to the fabricating process of the LSI or the VLSI, great attention must be paid to leave the ground layer as it is. Because, the ground layer of the LSI or the VLSI is very thin and any little part of it is not allowed to be etched.

There are many kinds of plasma ashing methods for removing the resist film provided on a insulating layer in a semiconductor device, however above all a down-flow ashing method is widely used. Because, applying the down-flow ashing method to the plasma ashing process, damage caused by charged particles can be avoided producing. The down stream ashing rate generally depends on a temperature, which will be called an "ashing temperature" hereinafter, of the resist so that the ashing rate decreases with the decrease of the ashing temperature. The ashing rate is usually expressed by the well known Arrhenius plot by which the ashing rates are plotted in a line against the inverse numbers of the respective ashing temperatures. In the Arrhenius plot, the gradient of the line gives the activation energy for ashing in such that when the ashing rate decreases rapidly with the decrease of the ashing temperature, the activation energy is large, and when the ashing rate changes only little with the decrease of the ashing temperature, the activation energy is small. On this, the small activation energy is desirable because the ashing can be performed almost independently on the ashing temperature, in other words, the ashing can be performed in stable and precisely.

Recently, there is a tendency that a wafer process in the fabrication process of a semiconductor device is performed at a lower temperature according as the semiconductor device has a higher integration circuit as seen in the LSI or the VLSI. The ashing process is desired to be performed lower than 300°C, most preferably lower than 200°C to avoid contamination from the resist. In order to maintain a large ashing rate at a low temperature, larger than 0.5 µm/min for practical use, the activation energy of the ashing rate must be also small. The activation energy of the ashing rate can be changed to some extent by changing the species of reactant gases used for ashing. The selection and the combination of the reactant gases are very important for making the ashing rate high and the activation energy small and for etching the resist precisely, leaving the ground layer as perfectly as possible and for minimizing damage. The selection and the combination of the reactant gases has been studied energetically.

### (2) Description of The Related Art

The downstream ashing is performed in a downstream of a microwave plasma using a microwave plasma resist stripper. This is fully disclosed in the paper titled "Heavy Metal Contamination From Resists during Plasma Stripping" by Shuzo Fujimura and Hiroshi Yano, in Elect. Chem. Soc. Vol. 135, No. 5, May 1988. .

The downstream of a microwave plasma resist stripper consists of a vacuum chamber including a plasma generating chamber, a vacuum pump for exhausting gas in the vacuum chamber, a process chamber including a pedestal on which a sample wafer is placed and a microwave power source. A reactant gas is supplied to the process chamber through the plasma generating chamber.

Then, a reactant gas plasma is generated in the plasma generating chamber by the microwaves, so that active species for ashing produced in the gas plasma flows down to the process chamber and reacts with a resist previously formed on the sample wafer so as to remove the resist.

In the down stream ashing process, oxygen has been used as the reactant gas for a long time as described before. However, when only oxygen is used, the ashing rate is small and the activation energy is large, so that the down stream ashing using only oxygen was hard to be applied to the fabricating process of the LSI or the VLSI. Therefore, many other reactant gases have been studied for increasing the ashing rate and decreasing the activation energy, by adding other kinds of gases to the oxygen. As a result, several kinds of effective reactant gases have been found as will be described below, giving four examples, a first, a second, a third and a fourth examples, tracing the development of the reactant gases. The ashing rate and the activation energy are related to removing the resist film provided in a semiconductor device by plasma ashing method, hereinafter.

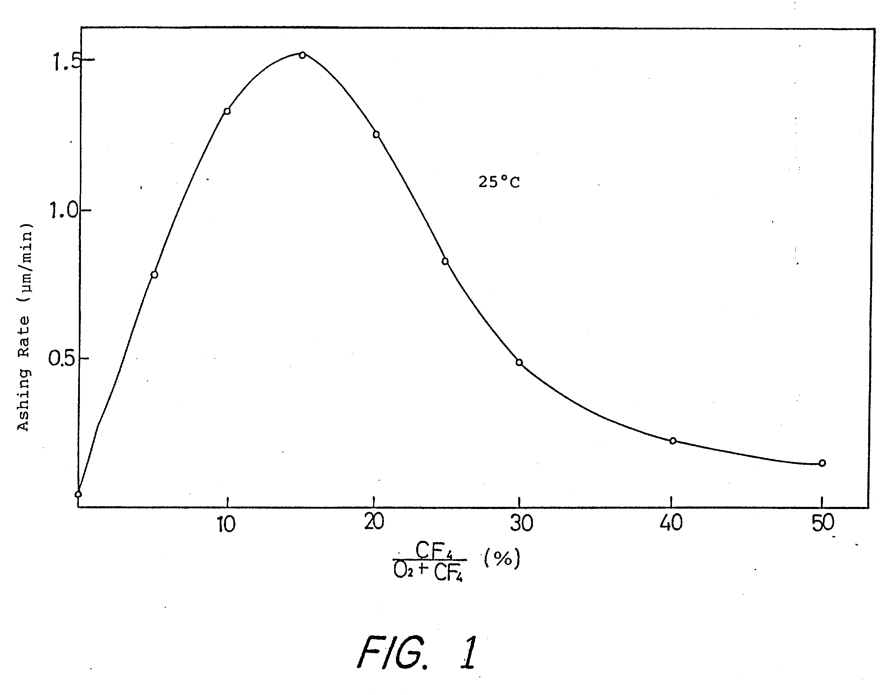

A first reactant gas was a mixed gas of oxygen (O₂) with a halogenide gas such as tetrafluoromethane (CF₄). The first reactant gas was most commonly used because it had a large ashing rate. Fig. 1 shows the ashing rate for commercially available photoresist(OFPR-800, TOKYO-OHKA) plotted against the variation of flow ratio of tetrafluoromethane to the mixed gas at room temperature. The ashing rate in the case using a reactant gas is simply called the ashing rate with the reactant gas, hereinafter. In Fig. 1, when tetrafluoromethane is added to oxygen as much as about 15% in the flow ratio, the ashing rate reaches a maximum value, 1.5 µm/min at 25°C, being large enough for practical use. However, the ground layer such as SiO₂, polysilicon (Si) or Al is etched because of fluorine (F) mixed in the first reactant gas. On the other hand, when the first reactnat gas is used, the activation energy is drastically reduced to a value of 0.1 eV from 0.52 eV which is the activation energy with only oxygen. Such large decrease of the activation energy is due to the tetrafluoromethane, which was explained in the paper, J.J.Hannon and J.M.Cook, J. Electrochem. Soc., Vol. 131, No. 5, pp 1164 (1984).

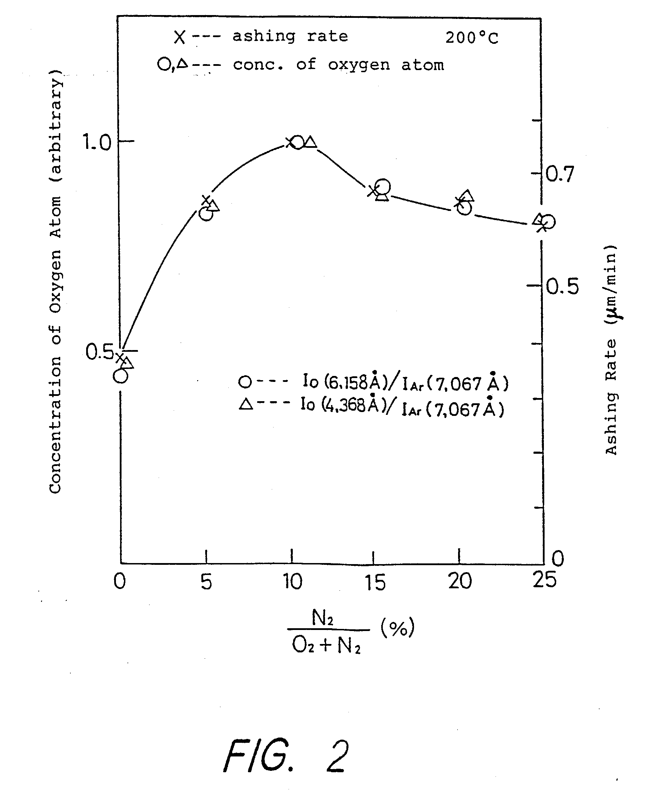

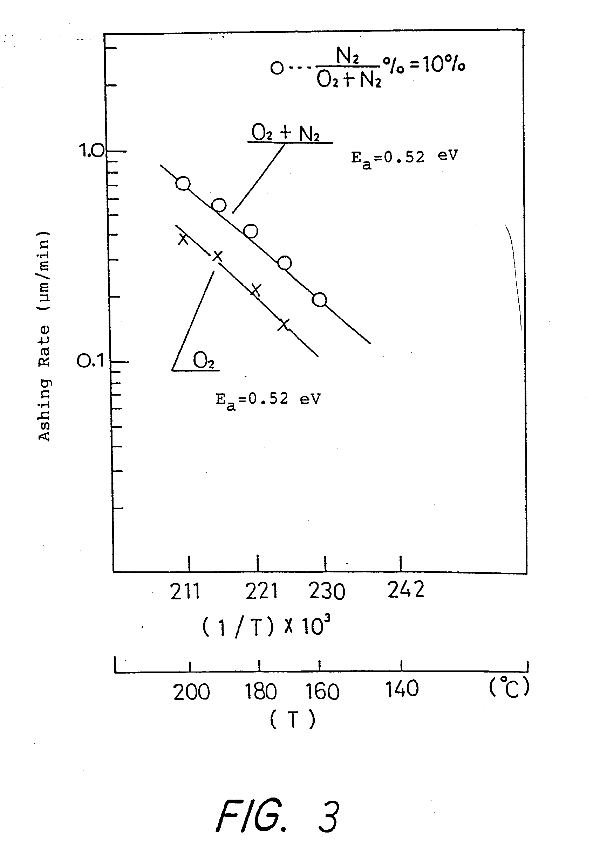

A second reactant gas was a mixed gas of oxygen and nitrogen (N₂), not containing fluorine (F), which did not etch the ground layer. The ashing rate and the concentration of oxygen atom in a down-flowed gas were measured by varying the flow ratio of nitrogen to the second reactant gas as shown in Fig. 2; wherein, the concentration of oxygen atom was measured by an actinometry method. In this case, the ashing temperature was 200°C and the flow rate of the second reactant gas was 1000 Standard Cubic Centimeter per Minute (SCCM). In Fig. 2, white circles represent the concentrations of oxygen atom, obtained from the spectral intensity ratio of the radiation from an oxygen atom (at a wavelength of 615,8 nm (6158 Å)) to the radiation from an argon atom (at a wavelength of 706,7 nm (7067 Å)) and triangles represent the concentrations of the same oxygen atom, obtained from the spectral intensity ratio of the radiation from an oxygen atom (at a wave length of 436,8 nm (4368 Å)) to the radiation from an argon atom (at a wavelength of 706,7 nm (7067 Å)). Further, the values of these concentrations are normalized by a maximum of the values of the concentrations, positioned at about 10% of the flow ratio of nitrogen to the second reactant gas. Multiplication signs represent the ashing rates to the flow ratio of nitrogen to the second reactant gas. As can be seen from Fig. 2, the curve of the ashing rate and that of the the concentration of oxygen atom are coincided each other, which means that oxygen atoms are only effective in performing the ashing. Fig. 3 shows the Arrhenius plot of the ashing rate when the second reactant gas contains 90% of oxygen and 10% of nitrogen in the flow ratio and the Arrhenius plot of the oxygen gas only. The ashing temperature is denoted by T. The ashing rate of the second reactant gas is plotted by a circle and the ashing rate of the oxygen is plotted by a multiplication sign. The ashing rate with the second reactant gas is about two times of that of oxygen only. The activation energy of ashing in the case using a reactant gas is simply called the activation energy of the reactant gas, hereinafter. The activation energy (Ea) of the second reactive gas, and that of the oxygen are equally 0.52 eV. That is, the activation energy does not change by mixing nitrogen. The ashing rate of the second reactive gas of 0.2 µm/min at 160 °C is too small for practical use. In order to increase the ashing rate, another kind of gas was needed.

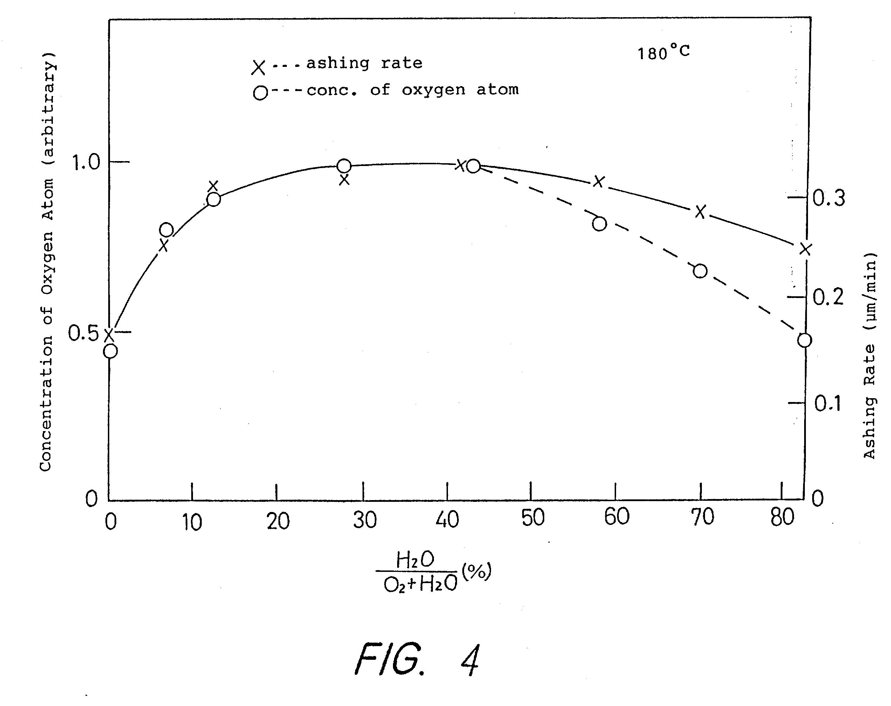

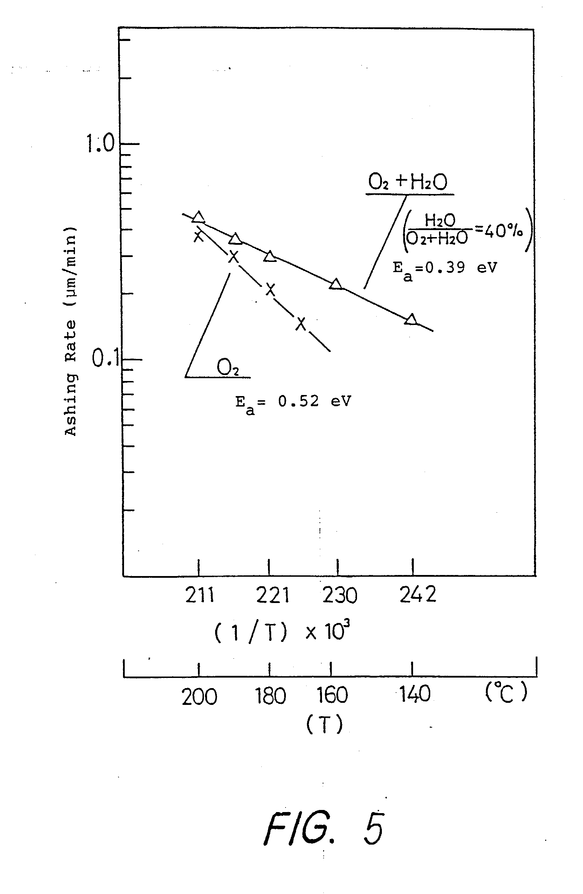

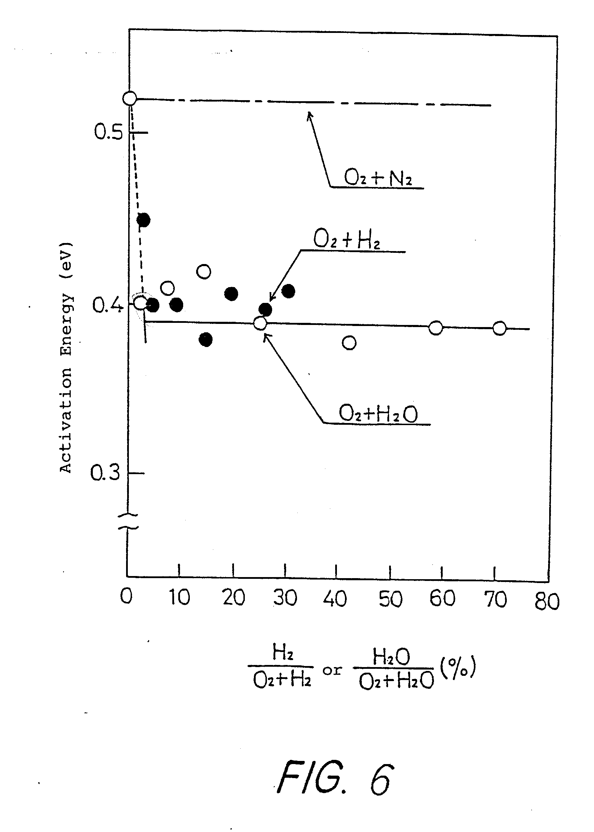

The third reactant gas was a mixed gas of oxygen and water vapor (H₂O) which did not etch the ground layer. The ashing rate and concentration of oxygen atom were measured by varying the flow ratios of water vapor to the third reactant gas as shown in Fig. 4. The measurements were performed under 180°C ashing temperature and 1000 SCCM flow rate of the third reactant gas. Circles and multiplication signs in Fig. 4 represent the same as in Fig. 2 respectively. When the flow ratio of water vapor to the third reactant gas exceeds 40%, the concentration of the oxygen atom decreases with the increase of the water vapor flow ratio. However, the ashing rate does not decrease so much as the decrease of the concentration of oxygen atom as seen in Fig. 4. This means that some active species except oxygen atoms are possible to take part in the ashing. Fig. 5 compares the Arrhenius plot of the third reactant gas containing 60% of oxygen and 40% of water vapor and Arrhenius plot of the oxygen gas. The ashing rate of the third reactant gas having 40% flow ratio of water vapor is plotted by triangles and the ashing rate of the oxygen is plotted by multiplication signs. The activation energy of the third reactive gas is 0.39 eV which is about three quarter of the activation energy (0.52 eV) of oxygen as shown in Fig. 6. Fig. 6 shows the activation energy of the ashing in the case using the third reactant gas by varying the flow ratios of water vapor to the third reactant gas, by white circles. In Fig. 6, the activation energy of ashing in the case using the mixed gas of oxygen and hydrogen by varying the flow ratio of hydrogen to the mixed gas is shown by solid circles, for the sake of comparison. It is seen in Fig. 6 that the activation energy is easily reduced by adding water vapor a little and the activation energy is constant independently on the flow ratio of water vapor when the flow ratio of water vapor exceeds 5%. The activation energy of the second reactant gas is also indicated by a dot chain line in Fig. 6 for the comparison with the third reactant gas. It is seen from this comparison that the activation energy does not change by adding nitrogen to oxygen. The behavior similar to the mixed gas of oxygen and water vapor is seen for the mixed gas of oxygen and hydrogen. On the other hand, the ashing rate of the third reactant gas is about o.22 µm/min at 160°C, as seen in Fig. 5. In conclusion, the value of the ashing rate of the third reactant gas is still too small for practical use.

The fourth reactant gas is a mixed gas of oxygen, nitrogen and tetrafluoromethane. The fourth reactant gas is disclosed in the Japanese laid-open patent application, SHO 63-102232, titled "DRY ETCHING APPARATUS" by Mikio Nonaka. When the flow ratio of tetrafluoromethane and nitrogen are in the range of 5 to 20% and 5 to 10% respectively, the large ratio of a rate of etching a positive resist to a rate of etching a ground layer is obtained without decreasing the ashing rate. However, the etching of ground layer can not be avoided occurring in this case.

A mixed gas made by adding as little as 0.2% of hydrogen to a mixed gas of oxygen, nitrogen and tetrafluoromethane is commercially available from EMERGENT TECHNOLGIES CO. (Phoenix 2320 NORD Photoresist Stripper). In this case, the hydrogen diluted by nitrogen is added in order to improve matching with microwave power. That is, the adding hydrogen to the mixed gas is not for reduction of the activation energy. So, the mixed gas is essentially the same as the first reactant gas. In fact, it is also known that the activation energy of the second reactant gas mixed with hydrogen does not decrease until up to 0.5% of hydrogen.

Other gas combinations have been disclosed in several published documents. For instance, document US-A-3837856 discloses oxygen as reactant gas, wherein the production of a high concentration of atomic oxygen is due in large part to catalytic effects by the presence of impurity gases, such as hydrogen, nitrogen or water vapor. The impurity level of commercially available oxygen is sufficient for the production of atomic oxygen in the desired quantities. However, the ratios of the catalytic gases can not be controlled, since theses catalytic gases are merely provided as impurities and, thus, their ratios depend on the type of the used oxygen.

In "JOURNAL OF THE ELECTROCHEMICAL SOCIETY", vol. 134, no. 4, August 1987, P. 2045 - 2048, the etching of photoresist with a gas mixture containing halogen or a compound of halogen, oxygen, water and nitrogen is disclosed. However, this document also fails to suggest a gas mixture, e.g. comprising three different gases; with a controlled ratio of each utilized gas.

Finally, document US-A4473437 discloses the etching of photoresist utilizing a mixture of oxygen and nitrogen, wherein the concentration of the oxygen is less than 30 mol% and the mixture rate is controlled. However, this document does not disclose a mixture used for oxygen-plasma etching comprising oxygen as the main part of the gas mixture.

As can be seen from the foregoing description of the various reactant gases, an ideal mixed gas with oxygen as the main part and with controllable ratios of the utilized gases, having a large ashing rate and a small activation energy and never etching the ground layer, has not been found although much has been studied on new reactant gases.

### SUMMARY OF THE INVENTION

Accordingly, an object of the present invention is to improve the ashing process for removing the organic film formed on the ground layer of the semiconductor device under fabrication, so that the ashing rate increases, the activation energy decreases and the ground layer is never etched in the ashing process.

This object is achieved by an ashing method for removing an organic material formed on a ground substance of a semiconductor device, the method comprising the steps of providing ashing means for performing the removement of the organic material by using a reactant gas plasma, supplying a mixed gas consisting essentially of oxygen as the main component, water vapor and an additional gas to the plasma ashing means, thereby obtaining a reactant gas with which the plasma ashing is performed in an ashing rate larger than and with activation energy at most equal to those respectively in the case of using a reactant gas composed of oxygen and water vapor, generating plasma of the reactant gas for producing active species being neutral of the reactant gas, and removing the organic material in down stream from the plasma by using the active species, without etching the ground substance, wherein according to the invention the additional gas is selected from a halogenide group consisting of tetrafluoromethane, chlorine, nitrogen trifluoride, hexafluoroethane and trifluoromethane and the flow ratios of the oxygen, the water vapor and the additional gas are controlled for obtaining the reactant gas so that a flow ratio of the water vapor to a gas composed of oxygen and water vapor is set so as to be more than 1 % and a flow ratio of the additional gas is set so that a number of hydrogen atoms liberated from said water vapor is greater than a number of halogen atoms liberated from the additional gas.

The mixed gas including the additional gas of halogenide as third gas, such as tetrafluoromethane, is excellent as the reactant gas. Recently, halogenide has not been used as the third gas in the fabrication of the LSI or the VLSI because of disadvantage that halogen easily etches the ground layer. However, according to the experiment by the inventors, it is found that the mixed gas including the third gas of halogenide does not etch the ground layer when the water vapor is included in the reactant gas, supplied by a flow ratio controlled so as to exceed a designated value. Because, the halogen atoms react to the hydrogen atoms of the water molecules. As the result, the action of the halogen is suppressed. Using the mixed gas including the third gas of halogen as the reactant gas, the ashing rate becomes large and the activation energy of the ashing rate becomes small, compared with a mixed gas including nitrogen as third gas.

The mixed gas according to the invention has three advantages of having a large ashing rate, having small activation energy and etching no ground layer in the fabrication process of the LSI or the VLSI.

### BRIEF DESCRIPTION OF THE DRAWINGS

Fig. 1 is a graph showing the variation of the ashing rate for resist in the case of using the reactant gas composed of O₂ and CF₄ with the flow ratio of CF₄ to the reactant gas, at 25°C ashing temperature.

Fig. 2 is a graph showing the variation of the ashing rate for resist in the case of using the reactant gas composed of O₂ and N₂ at 200°C ashing temperature and the variation of the concentration of oxygen atom in a down-flowed gas with the flow ratio of N₂ to the reactant gas.

Fig. 3 is a graph showing Arrhenius plots of the ashing rate for resist in the case of using the reactant gas composed of O₂ having 90% flow ratio, N₂ having 10% flow ratio and the reactant gas composed of oxygen.

Fig. 4 is a graph showing the variation of the ashing rate in the case of using the reactant gas composed of O₂ and H₂O at 180°C ashing temperature and the variation of the concentration of oxygen atom in a down-flowed gas with the flow ratio of H₂O to the reactant gas.

Fig. 5 is a graph showing Arrhenius plots of the ashing rate for in the case of using the reactant gas composed of O₂ having 60% flow ratio, H₂O having 40% flow ratio and the reactant gas composed of oxygen.

Fig. 6 is a graph showing the variation of the activation energy of the ashing using the reactant gas composed of O₂ and H₂O with the flow ratio of H₂O to the reactant gas.

Fig. 7 is a schematical drawing of a vacuum chamber of a down-flow ashing apparatus.

Fig. 8 is a graph, represented in Arrhenius plots, showing the ashing rates for resist in the case of using different kinds of reactant gases.

Fig. 9 is a graph showing variations of the rate of etching SiO₂ layer at 150°C and 25°C ashing temperature with flow ratio of H₂O to the mixed gas, in the case of performing the plasma ashing using the reactant gas composed of O₂, H₂O and CF₄.

Fig. 10 is a graph showing the variations of the ashing rate for resist in the case of using the reactant gas composed of O₂, H₂O and CF₄ at 25°C, 150°C and 180°C ashing temperature with flow ratio of H₂O to the reactant gas, where 15% flow ratio of CF₄ to the mixed gas of O₂ and CF₄ is kept.

### DESCRIPTION OF THE INVENTION

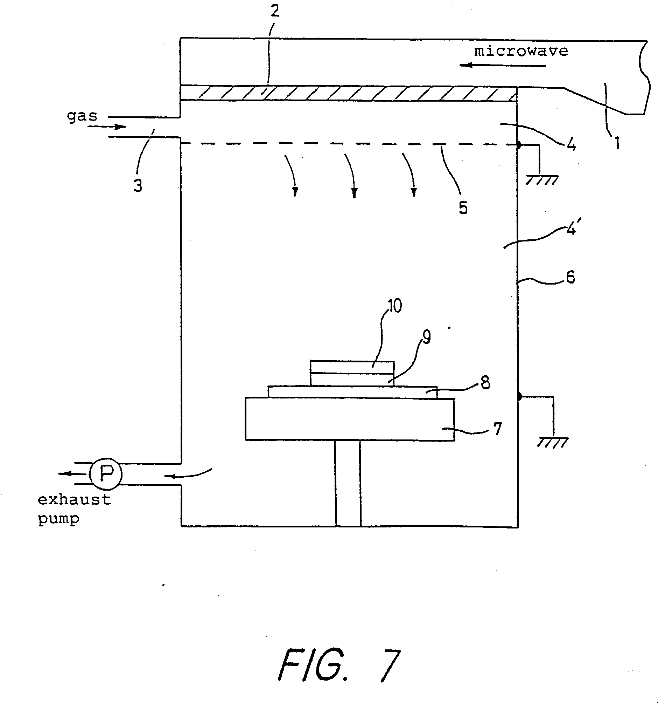

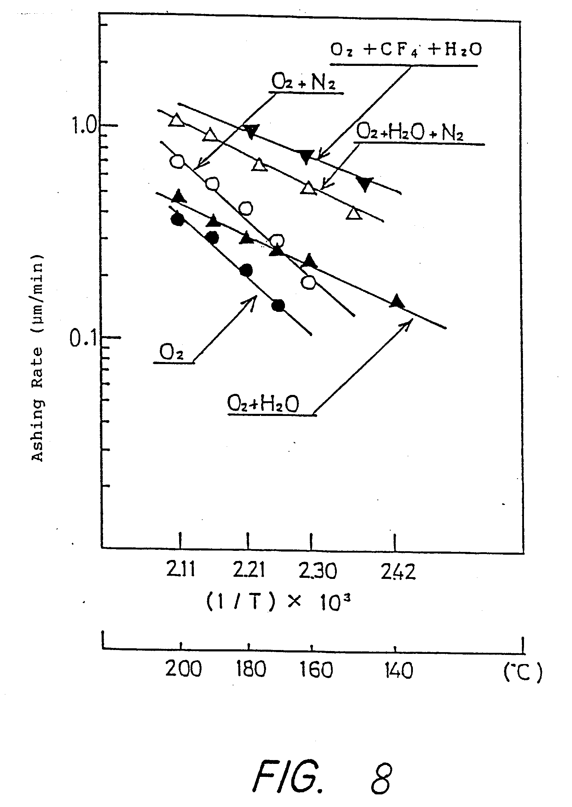

The invention will be described with reference to Figs. 8 to 10. The plasma ashing is performed by a down flow ashing method using a conventional downstream microwave plasma resist stripper schematically shown in Fig. 7.

In Fig. 7, the reactant gas is supplied to an initially exhausted vacuum chamber 6 through a gas inlet 3, keeping the gas pressure in the vacuum chamber 6 at about 106,658 Pa (0.8 Torr). The flow rates of the gases are controlled respectively by a controller, not depicted, before the gases flow into the vacuum chamber 6. Through a wave guide 1 and a window 2, microwave power of 2.45 GHz is supplied into a plasma generating chamber 4. Plasma is generated with the reactant gas in the plasma generating chamber 4 and the charged particles in the plasma are trapped by a shower plate 5. Then, only neutral active species, generated in the plasma, flow down to a process chamber 4' through the holes provided in a showerhead plate 5 and touch a surface of a resist 10 formed on a ground layer 9 of a sample wafer 8 placed on a stage 7 heated at 140°C by a heater not depicted. As a result, the resist 10 is etched until the surface of the ground layer 9 appears without etching any part of the ground layer.

The ashing rate in the case of using the reactant gas is shown by a line connecting black inverted triangles in Fig. 8 represented in Arrhenius plot. In Fig. 8, the ashing rates in the case of using other several kinds of reactant gases are also shown in the same way, for the sake of comparison. That is, the ashing rate in the case of using the reactant gas composed of only O₂, that of using the reactant gas composed of O₂ and H₂O and that of using the reactant gas composed of O₂ and N₂ are shown by solid circle, solid triangle and white circle respectively. As seen in Fig. 8, the ashing rate in the case of using the reactant gas is larger than the ashing rate in the cases of using the reactant gas composed of only O₂, of O₂ and H₂O, and of O₂ and N₂. The reactant gas has the ashing rate of 0.5 µm/min at 160°C ashing temperature and the activation energy of 0.4 eV. For practical use, the 0.5 µm/min ashing rate is large enough and the 0.4 eV activation energy is small enough.

The flow rate of H₂O is not limited if the flow ratio of H₂O to the mixed gas of O₂ and H₂O is larger than 1%, because the activation energy is about 0.4 eV regardless of the flow ratio when the flow ratio exceeds 1%, as seen in Fig. 6.

NOₓ or H₂ can be added to the mixed gas of O₂ and H₂O instead of N₂.

### Embodiment of the Invention

According to an embodiment of the invention, the reactant gas composed of O₂, H₂O and CF₄ is used for the plasma ashing. The ashing is performed in the same way as described with reference to Fig. 7. The flow rates of O₂, H₂O and CF₄ are 730 SCCM, 150 SCCM and 120 SCCM, respectively.

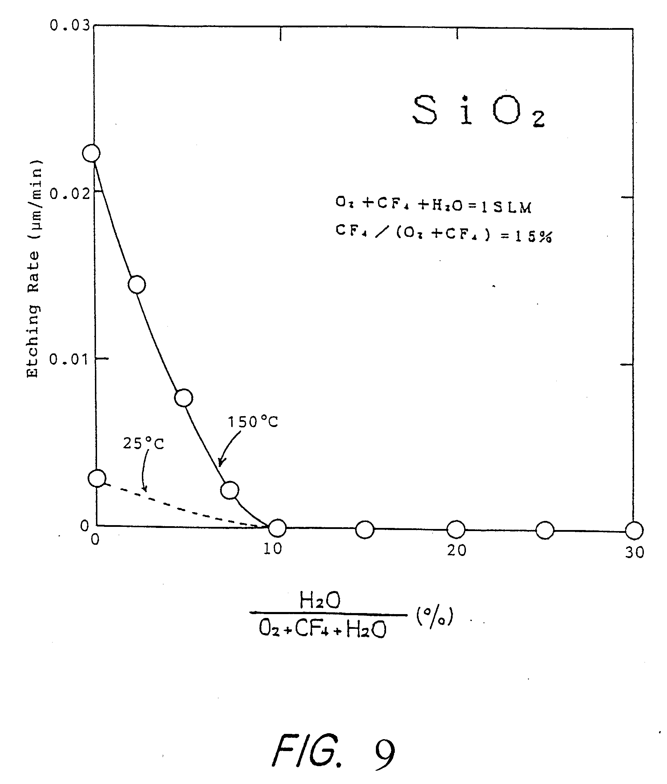

The disadvantage of etching the ground layer by using CF₄ can be avoided occurring when the flow ratio of H₂O to the reactant gas is controlled so as to be larger than 10% as shown in Fig. 9. Fig. 9 is a graph showing the etching rate, at 150°C and 25°C ashing temperature, of a ground layer made of SiO₂, with the flow ratio of H₂O to the reactant gas, under a condition that the total flow rate of O₂, H₂O and CF₄ is kept in 1000 SCCM and the flow ratio of CF₄ to the mixed gas of O₂ + CF₄ is kept in 15%. From Fig. 9, it can be seen that when the flow ratio of H₂O to the reactant gas exceeds 10%, the etching rate of the ground layer of SiO₂ becomes zero, in other words, the ground layer of SiO₂ is never etched. Thus, this 10% of the H₂O ratio is a very important percentage to avoid the ground layer being etched. Incidentally, when the H₂O ratio to the reactant gas is 10%, it can be calculated from the above condition in Fig. 9 that the flow ratios of O₂ and CF₄ to the reactant gas are 76.5% and 13.5% respectively.

The ashing rate of the reactant gas composed of O₂, H₂O and CF₄ is shown by a line connecting reversed solid triangles in Fig. 8. As shown in Fig. 8, the ashing rate is the largest, compared with other ashing rates in the cases of using other reactant gases.

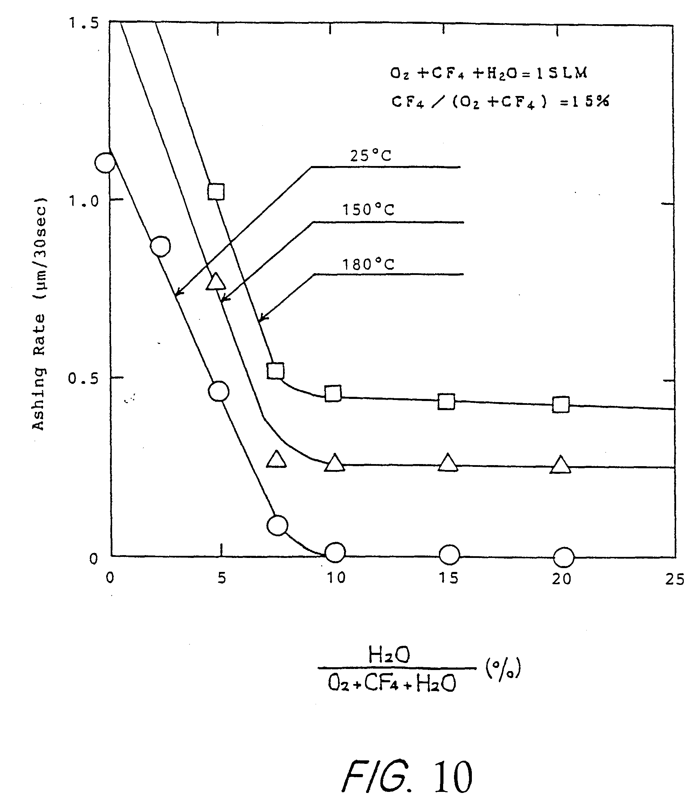

The ashing rate of the reactant gas composed of O₂, H₂O and CF₄ was measured by varying the flow ratio of H₂O to the reactant gas at 25°C, 150°C and 180°C ashing temperature respectively, under a condition that the total flow rate of O₂, H₂O and CF₄ was kept in 1000 SCCM and the flow ratio of CF₄ to the mixed gas of O₂ and CF₄ was kept in 15% . The results of the measurement are shown in Fig. 10 where it can be seen that when the flow ratio of H₂O to the reactant gas exceeds 10%, the ashing rate is constant and independent of flow ratio of H₂O to the reactant gas.

The flow rate of each component gas is set 730 SCCM, 150 SCCM and 120 SCCM for O₂, H₂O and CF₄, respectively, as a desirable example. However flow rate of H₂O is not limited if the number of hydrogen atoms of H₂O is larger than the number of fluorine atoms liberated from CF₄. On the other hand, the flow ratio of H₂O to the mixed gas of O₂ and H₂O must be larger than 1%, so that the activation energy of ashing in the case of using the reactant gas is about 0.4 eV regardless of the flow ratio, as seen in Fig. 6.

In the present embodiment, CF₄ is used as a halogenide, however Cl₂, NF₃, C₂F₆ and CHF₃ can be used instead of CF₄.

The embodiment described above is related to removing the resist film by plasma ashing, however the present invention can be applied to removing the organic polymer film.

Though the reactant gases described in the embodiment are composed of three kinds of gases, an inert gas such as He, Ne or Ar can be added to the reactant gases up to 7%.

## Claims

1. An ashing method for removing an organic material formed on a ground substance of a semiconductor device (8), said method comprising the steps of:
providing ashing means for performing the removement of the organic material by using a reactant gas plasma;
supplying a mixed gas consisting essentially of oxygen as the main component, water vapor and an additional gas to said plasma ashing means, thereby obtaining a reactant gas with which the plasma ashing is performed in an ashing rate larger than and with activation energy at most equal to those respectively in the case of using a reactant gas composed of oxygen and water vapor;
generating plasma of the reactant gas for producing active species being neutral of the reactant gas; and
removing the organic material in down stream from said plasma by using said active species, without etching the ground substance,
**characterized in that**
said additional gas is selected from a halogenide group consisting of tetrafluoromethane, chlorine, nitrogen trifluoride, hexafluoroethane and trifluoromethane, and
the flow ratios of the oxygen, the water vapor and said additional gas are controlled for obtaining said reactant gas so that a flow ratio of the water vapor to a gas composed of oxygen and water vapor is set so as to be more than 1 % and a flow ratio of the additional gas is set so that a number of hydrogen atoms liberated from said water vapor is greater than a number of halogen atoms liberated from said additional gas.

2. A method according to claim 1,
**characterized by further comprising the step of**
setting a temperature of the organic material at higher than 140 °C, so as to obtain an ashing rate larger than 0.5 µm/min.

## Patentansprüche

1. Veraschungsverfahren zur Entfernung eines auf einer Bodensubstanz einer Halbleiteranordnung (8) ausgebildeten organischen Materials, wobei das Verfahren die Schritte umfaßt:
Bereitstellen von Veraschungsmitteln zur Durchführung der Entfernung des organischen Materials durch Verwendung eines Reaktionsgasplasmas,
Zuführen eines Mischgases zu den Plasmaveraschungsmitteln, wobei das Mischgas im wesentlichen aus Sauerstoff als Hauptbestandteil, Wasserdampf und einem zusätzlichen Gas besteht, wodurch ein Reaktionsgas erhalten wird, mit dem die Plasmaveraschung mit einer höheren Veraschungsrate und einer nahezu gleichen Aktivierungsenergie wie im Fall der Verwendung eines aus Sauerstoff und Wasserdampf bestehenden Reaktionsgases durchgeführt wird,
Erzeugen eines Plasmas des Reaktionsgases, zur Erzeugung von neutralen aktiven Teilchen des Reaktionsgases, und
Entfernen des in Strömungsrichtung des Plasmas angeordneten organischen Materials mit Hilfe der aktiven Teilchen, ohne die Bodensubstanz zu ätzen,
**dadurch gekennzeichnet,**
daß das zusätzliche Gas aus einer Halogenidgruppe ausgewählt wird, die Tetrafluormethan, Chlor, Fluorstickstoff, Hexafluorethan und Trifluormethan umfaßt, und
daß die Flußanteile des Sauerstoffs, des Wasserdampfes und des zusätzlichen Gases zur Erhaltung des Reaktionsgases derart gesteuert werden, daß ein Flußanteil des Wasserdampfes in einem aus Sauerstoff und Wasserdampf bestehenden Gas auf einen Wert größer als 1% eingestellt wird und ein Flußanteil des zusätzlichen Gases derart eingestellt wird, daß eine Anzahl von aus dem Wasserdampf freigesetzten Wasserstoffatomen größer ist als eine Anzahl von aus dem zusätzlichen Gas freigesetzten Halogenatomen.

2. Verfahren nach Anspruch 1,
**gekennzeichnet durch** den weiteren Schritt
Einstellen einer Temperatur des organischen Materials auf einen Wert größer als 140 °C, um eine Veraschungsrate größer als 0,5 µm/min zu erhalten.

## Revendications

1. Procédé d'incinération pour éliminer un matériau organique formé sur une substance de base d'un dispositif semi-conducteur (8), ledit procédé comprenant les étapes consistant :
- à fournir un moyen d'incinération pour réaliser l'élimination du matériau organique en utilisant un plasma de gaz de corps réagissant
- à introduire un gaz mixte essentiellement constitué d'oxygène en tant que constituant principal, de vapeur d'eau et d'un gaz supplémentaire dans ledit moyen d'incinération au plasma, obtenant par la un gaz de corps réagissant avec lequel on réalise l'incinération au plasma respectivement avec vitesse d'incinération supérieure à et une énergie d'activation au moins égale à celles du cas de l'utilisation d'un gaz de corps réagissant composé d'oxygène et de vapeur d'eau;
- à produire un plasma du gaz de corps réagissant pour produire des espèces actives étant neutres par rapport au gaz de corps réagissant; et
- à éliminer le matériau organique dans un courant descendant à partir dudit plasma en utilisant lesdites espèces actives, sans graver la substance de base,
caractérisé en ce que
- ledit gaz supplémentaire est choisi dans d'un groupe d'halogénures constitué de tétrafluorométhane, de chlore, de trifluorure d'azote, d'hexafluoroéthane et de trifluorométhane, et
- les débits partiels de l'oxygène, de la vapeur d'eau et dudit gaz supplémentaire sont réglés pour obtenir ledit gaz de corps réagissant de telle sorte que le débit partiel de la vapeur d'eau du gaz composé d'oxygène et de vapeur d'eau est fixé pour être supérieur à 1% et le débit partiel du gaz supplémentaire est fixé de telle sorte que le nombre d'atomes d'hydrogène libérés à partir de ladite vapeur d'eau est supérieur au nombre d'atomes d'halogène libérés à partir dudit gaz supplémentaire.

2. Procédé selon la revendication 1, caractérisé en ce qu'il comprend en outre l'étape consistant
- à fixer une température du matériau organique à une valeur supérieure à 140°C afin d'obtenir une vitesse d'incinération supérieure à 0,5 µm/min.
